Europäisches Patentamt

European Patent Office

Office européen des brevets

(19)

(11) Publication number: **0 240 567 B1**

# EUROPEAN PATENT SPECIFICATION

(12)

(45) Date of publication of patent specification: **07.10.92**

(51) Int. Cl.5: **H01L 29/72,** H01L 27/06, H01L 29/20, H01L 29/73

(21) Application number: **86904403.2**

(22) Date of filing: **23.07.86**

(86) International application number:
**PCT/JP86/00391**

(87) International publication number:
**WO 87/00692 (29.01.87 87/03)**

(54) SEMICONDUCTOR DEVICE.

(30) Priority: **26.07.85 JP 164128/85**
**26.07.85 JP 164126/85**
**27.02.86 JP 40244/86**

(43) Date of publication of application:
**14.10.87 Bulletin 87/42**

(45) Publication of the grant of the patent:
**07.10.92 Bulletin 92/41**

(84) Designated Contracting States:
**DE FR GB**

(56) References cited:
EP-A- 0 133 342     EP-A- 0 144 242
EP-A- 0 159 273     JP-A- 6 050 956
JP-A- 6 052 055     JP-A- 6 153 769
JP-A-58 100 456     JP-A-61 102 775

IEEE ELECTRON DEVICE LETTERS, vol. EDL-6, no. 4, April 1985, pages 178-180, IEEE, New York, US; S. LURYI: "An induced base hot-electron transistor"

(73) Proprietor: **HITACHI, LTD.**

6, Kanda Surugadai 4-chome
Chiyoda-ku, Tokyo 101(JP)

(72) Inventor: **USAGAWA, Toshiyuki**
Hitachi-dai 4 kyoshin-ryo 4-14-6,
Nishikoigakubo
Kokubunji-shi Tokyo 185(JP)
Inventor: **YAMANE, Masao**
Hitachi-dai 4 kyoshin-ryo 4-14-6,
Nishikoigakubo
Kokubunji-shi Tokyo 185(JP)
Inventor: **GOTO, Shigeo**
Hitachi-dai 4 kyoshin-ryo 4-14-6,
Nishikoigakubo
Kokubunji-shi Tokyo 185(JP)
Inventor: **UMEMOTO, Yasunari**
D-107, Hitachi-Koyasudai-apart 2-32, Koyasu-cho
Hachioji-shi Tokyo 192(JP)

S.M. Sze, "Physics of Semiconductor Devices", 2nd Edition (Wiley, New York, 1981), pages 558-565

NIKKEI ELECTRONICS NO. 360, 14 January 1985 (14.01.85) (Tokyo), Ogawa Masatoshi and two others, pp. 213-240

Inventor: **HASHIMOTO, Norikazu**
**2-19-14, Nanyoudai**
**Hachioji-shi Tokyo 192(JP)**
Inventor: **ITOH, Hiroyuki**
**A-3-2, Suzuki-Shinden-syataku 1473, Jousuihoncho**
**Kodaira-shi Tokyo 187(JP)**
Inventor: **MISHIMA, Tomoyoshi**
**1-12-10, Kamimuneoka**
**Shiki-shi Saitama 353(JP)**

(74) Representative: **Strehl, Schübel-Hopf, Groening**
**Maximilianstrasse 54 Postfach 22 14 55**
**W-8000 München 22(DE)**

**Description**

Technical Field:

The present invention relates to semiconductor devices, and more particularly to a semiconductor device having a heterojunction bipolar, transistor (HBT).

Background Art:

A heterojunction bipolar transistor (abbreviated to 'HBT') is a transistor characterized in that a base-emitter junction is formed by making an emitter out of a semiconductor whose band gap is wider than in a base, thereby to reduce the amount of injection of minority carriers from the base into the emitter. Thus, the injection efficiency of majority carriers from the emitter into the base can be enhanced, and the impurity concentration of the base can be heightened, so that a transistor of high current gain and low base resistance is realized. An HBT employing a heterojunction of $Ga_{x-1}AL_xAs$-GaAs is found in, for example, the following literature: Proceedings of the 12th Conf on Solid State Devices, 1980, p. 1.

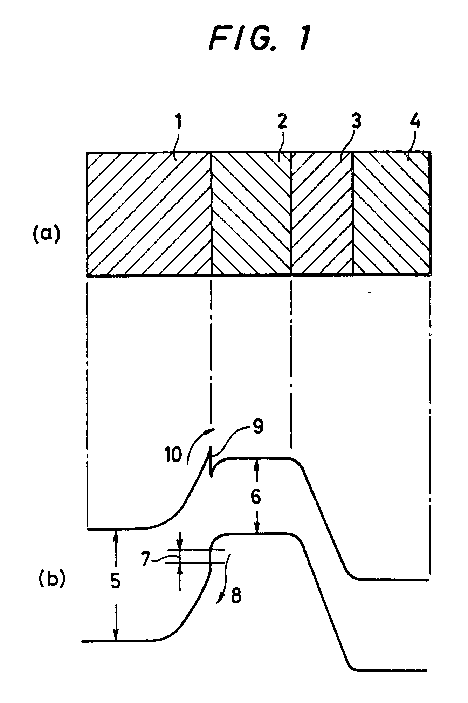

Figs. 1(a) and 1(b) show the cross sectional structure and band structure of the operation region of an n-p-n type HBT, respectively. This transistor is constructed of an emitter 1 made of n-type $Ga_{0.7}Al_{0.3}As$, a base 2 made of a p-type GaAs layer, and a collector made up of an n-type GaAs layer 3 and an $n^+$-type GaAs layer 4. The band gap 5 of $Ga_{0.7}Al_{0.3}As$ is 1.79 eV, which is about 0.37 eV wider than the band gap 6 of GaAs. Of the difference, about 0.05 eV is distributed to a valence band, and by this component (indicated as $\Delta E_v$) 7, the energy level of the emitter lowers to suppress the base current $I_B$ 8 of holes.

In addition, the band gap comes to have a notch (indicated as $\Delta E_c$) 9 of 0.32 eV at a hetero-interface on the side of a conduction band.

Letting $I_E$ denote the emitter current 10, the current gain $h_{FE}$ can be expressed as follows:

$$h_{FE} = I_E/I_B$$
$$\propto \frac{L_E\ N_D\ v_e}{W_B\ N_A\ v_h}\ e^{\Delta E_v/kT} \qquad \ldots\ldots(1)$$

where $N_D$ denotes the carrier density of the emitter, $N_A$ the carrier density of the base, $v_e$ the drift velocity of an electron, $v_h$ the drift velocity of a hole, $L_E$ the diffusion length of a hole in the emitter, $W_B$ the width of the base, k Boltzmann's constant, and T a temperature.

Usually, in the prior-art device, $N_D$ is approximately $7 \times 10^{17}$ cm$^{-3}$, $N_A$ is approximately $1 \times 10^{19}$ cm$^{-3}$ for the purpose of lowering the base resistance, and $W_B$ is approximately 100nm (1000 Å) because of depletion layers at the interface between the base and the emitter and the interface between the base and the collector. Therefore, the current gain has been limited to approximately 100.

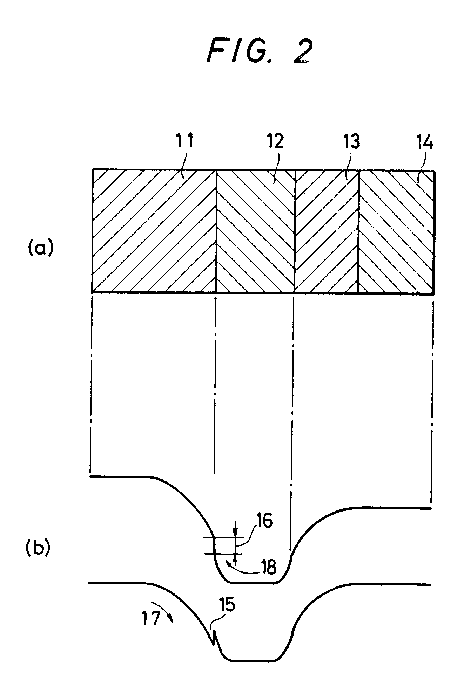

A p-n-p type heterojunction bipolar transistor differs in the band structure from the n-p-n type one, and the cross - sectional structure and band structure of the operation region thereof are respectively shown in Figs. 2(a) and 2(b). This transistor is constructed of an emitter 11 made of p-type $Ga_{0.7}Al_{0.3}As$, a base 12 made of an n-type GaAs layer, and a collector made up of a p-type GaAs layer 13 and a $p^{++}$-type GaAs layer 14. The p-n-p type heterojunction bipolar transistor is different from the n-p-n type in that a notch ($\Delta E_c$) 15 in the band gap appears on the side of the valence band. Besides, in the conduction band, the energy level of the base lowers by $\Delta E_v$ 16 so as to suppress the base current $I_B$ 18 of electrons. Letting $I_E$ denote the emitter current 17, the current gain $h_{FE}$ in the case of the p-n-p type can be expressed as follows:

$$h_{FE} = I_E/I_B$$
$$\propto \frac{L_E\ \tilde{N}_A\ v_h}{W_B\ \tilde{N}_D\ v_e}\ e^{\Delta E_c/kT} \qquad \ldots\ldots(2)$$

where $N_D$ denotes the carrier density of the base, and $\tilde{N}_A$ the carrier density of the emitter.

The great difference from the $h_{FE}$ of the n-p-n type HBT is that the exponential index changes from $\Delta E_v$

3

to $\Delta E_c$.

Although $\Delta E_v$ is 0.05 eV, $\Delta E_c$ is 0.32 eV and is about 6 times greater, so that the $h_{FE}$ can be enlarged at least approximately 10000 times at the room temperature. With this structure, however, the minimum value of the base width remains limited to approximately 50 nm. Since the diffusion coefficient of a hole is therefore small as compared with that of an electron, the transit time in the base region is long, and hence, it has been impossible to heighten the cutoff frequency $f_T$. This is the reason why the p-n-p type heterojunction bipolar transistor has not been fabricated.

With the heterojunction bipolar transistors of the n-p-n and p-n-p type structures described above, the simultaneous attainment of the two themes of reducing the base width and lowering the resistance of the base region is impossible in principle because the base width and the resistance of the base region are substantially in an inversely proportional relationship. In "Physics of Semiconductor Devices" (Wiley, New York, 1981, pp. 558 - 565), a tunneling-base transistor is discussed, which comprises an emitter and a collector both made of a p-type GaAsSb and a n-type GaInAs base. The operation of this type of transistor is based on the tunneling effect, which requires a thin base layer (5 nm) and a high impurity density in the base region. However, the layer-structure and the corresponding energy band diagram is quite different from that of an HBT.

"IEEE Electron Device Letters" (EDL-6, April 1985, pp. 178 - 180) discloses an induced base hot-electron transistor, wherein a two-dimensional electron gas is used as a base layer, which allows designing this layer as thin as 10 nm without loss in sheet conductance. The transistor comprises an $n^+$-emitter, an undoped emitter barrier, an undoped quantum well base, an undoped collector barrier and an $n^+$-doped collector.

Summary of the invention:

An object of the present invention is to solve the disadvantages of the prior-art heterojunction bipolar transistors stated above, and to provide a heterojunction bipolar transistor having high current gain $h_{FE}$ and cut off frequency $f_T$ and low base resistance.

The fundamentals of the present invention will be described by examplifying a case of employing an $Al_xGa_{1-x}As/GaAs$ heterojunction.

The prior-art n-p-n type HBT is designed so that the depletion layer from the collector side and the depletion layer from the emitter side may not come into touch within the base layer, thereby making it possible to attain a sufficient collector breakdown voltage, and the width of the base layer cannot be set less than approximately 50 nm because the lowering of the base resistance is intended. On the other hand, with the prior-art p-n-p type HBT, $\Delta E_c$ is 0.32 eV and is great as compared with the room temperature, so that the $h_{FE}$ can be enlarged as indicated by Eq. (2). Since, however, the drift velocity of holes in the base region is low, the base transmit time becomes too long, and the operating speed cannot be made high.

The present invention provides an HBT (heterojunction base HBT) of new structure in which, in a p-n-p type HBT, a base region is replaced with a two-dimensional electron gas layer employing an $Al_xGa_{1-x}As/GaAs$ heterojunction while $h_{FE}$ is kept high (for example, 10000), thereby making it possible to narrow the base layer down to the thickness (~10 nm) of the two-dimensional electron gas(2D EG) layer and to neglect, in effect, the transit time of holes in the base region, and in which the two-dimensional electron gas of high mobility is used, thereby making it possible to lower the resistance of the base and to operate the HBT at high speed.

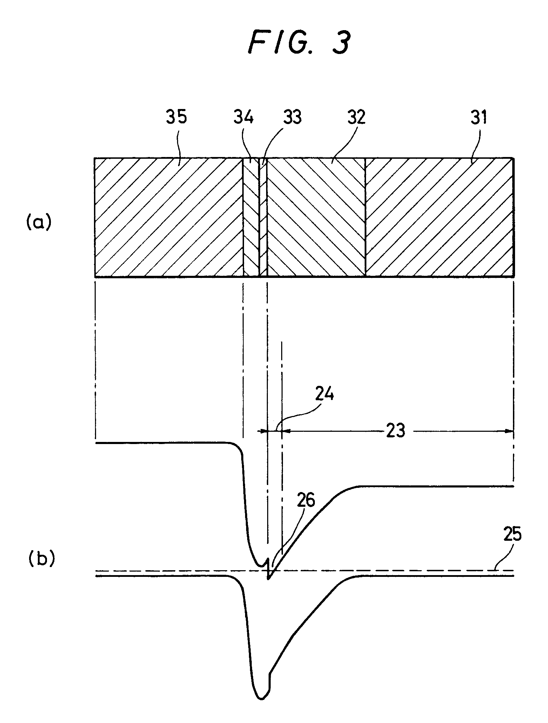

Next, the operating principle and merits of the present invention will be described in conjunction with the structural sectional and band structural diagrams (Figs. 3(a) and 3(b)) of the 2DEG-HBT (p-type $Al_xGa_{1-x}As/n-tyPe$ $Al_xG_{1-x}As/undoped$ GaAs/p-type GaAs HBT) of the present invention.

A collector region 23 consists of the two layers of a $p^+$-type GaAs layer 31 and an undoped (in substance, $p^-$) GaAs layer 32. A base region 24 is a two-dimensional electron gas which is formed at the interface of the heterojunction between the undoped ($p^-$) GaAs layer 32 and an $n^-$-type $Al_xGa_{1-x}As$ layer (x:~0.3 or so) as well as an $n^+$-type $Al_xGa_{1-x}As$ layer 34. An emitter layer is a $p^+$-type $Al_xGa_{1-x}As$ layer 35. The transmit time $\tau$ of holes in the base region has the relation:

$$\tau = W_B^2/D_B$$

Here, $W_B$ denotes the base width, and $D_B$ the diffusion coefficient of the holes being minority carriers.

Since, in the p-n-p type HBT, the diffusion coefficient $D_B$ is proportional to the hole mobility $\mu_h$ in accordance with the Einstein relation ($D_B \propto \mu_h$), it is about two orders smaller as compared with the diffusion coefficient of electrons. As a result, it has been impossible to make $\tau$ small.

Since, however, $W_B$ is influential on $\tau$ in square, the base transit time $\tau$ forming a limiting factor for a raised operating speed can be made equal to or less than the other factors by rendering $W_B$ very small.

When the two-dimensional electron gas layer is employed as the base in the way of the present invention, the thickness of this two-dimensional electron gas layer becomes the base width, and the base width $W_B$ 24 (10 - - 15 nm) which is about one-fifth or less as compared with the base width of the prior-art type can be realized.

On the other hand, the resistance of the base region increases due to the reduction of the base width $W_B$ in an ordinary HBT. In this regard, to the end of keeping the resistance low, the two-dimensional electron gas 26 is formed at the interface (heterojunction) between the collector region and the base region. Since this two-dimensional electron gas 26 is stored at a high density ($\sim 1 \times 10^{12}$ cm$^{-2}$) in the undoped GaAs layer of high mobility on the collector side below a Fermi level 25, it becomes possible to lower the resistance of the base.

Regarding the current gain $h_{FE}$, also in the case of the present invention, the following relation holds as in the prior-art type HBT:

$$h_{FE} \propto e^{\Delta E_c / kT}$$

Therefore, a high $h_{FE}$ and a high $f_T$ as well as a low base resistance can be realized.

In the above, the present invention has been described as to the enhancement of the operating speed of an HBT by taking the n-p-n type heterojunction base HBT as an example. However, the invention need not be restricted to the $Al_xGa_{1-x}As/GaAs$ system as materials and is also applicable to the case of the n-p-n type. For instance, the use of an $Al_xGa_{1-x}As$ ($0 \leq x \leq 1$)/Ge system intended to enhance the operating speed of an n-p-n type HBT will be described.

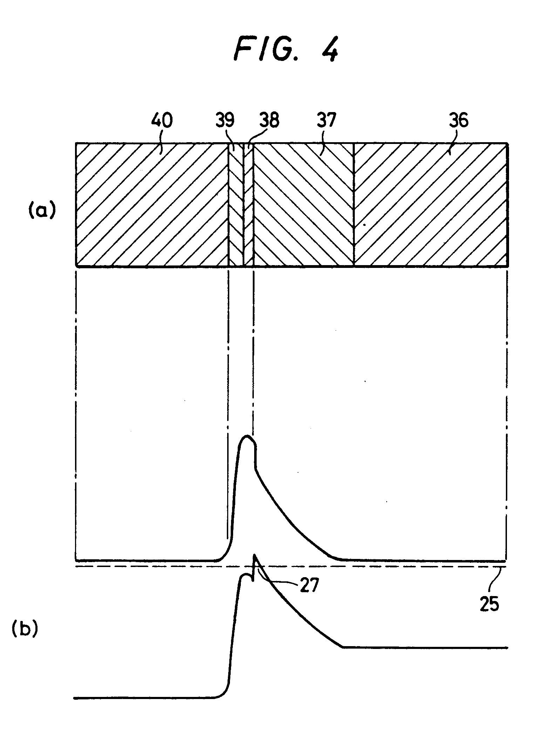

Figs. 4(a) and 4(b) show the structural cross sectional diagram and band structural diagram of an n-p-n type heterojunction base HBT, respectively. A collector region consists of an $n^+$-type Ge layer 36 and an undoped Ge layer 37, and a base region is a two-dimensional hole gas which is formed at the heterojunction interface of a $p^-$-type $Al_xGa_{1-x}As$ ($0 \leq x \leq 1$) layer 38 and a $p^+$-type $Al_xGa_{1-x}As$ ($0 \leq x \leq 1$) layer 39. An emitter layer is made of an $n^+$-type $Al_xGa_{1-x}As$ ($0 \leq x \leq 1$) layer 40. In principle, this type may be considered the same as the p-n-p type described before. Herein, however, the two-dimensional hole gas 27 is formed instead of the two-dimensional electron gas 26.

As in the p-n-p type, the transit time of electrons in the base region has the relation:

$$\tau \propto W_B^2/D_B$$

In the case of the n-p-n type, however, minority carriers are the electrons, so that the diffusion coefficient $D_B$ is proportional to the mobility of the electrons. In this manner, when Ge is employed for the base, the $D_B$ is great, and by reducing the base width, the effect of the transit time in the base region on the enhancement of the operating speed can be neglected completely. Besides, the base resistance can be suppressed low as in the p-n-p type by employing a high two-dimensional density hole gas at a sheet concentration of approximately $3 \times 10^2$ cm$^{-2}$. Moreover, the current gain $h_{FE}$ is related to $\Delta E_v$ 15 as follows:

$$h_{FE} \propto e^{\Delta E_v / kT}$$

as in the prior-art type. Thus, increase in the current gain can be achieved in a case where $\Delta E_v$ (0.7) is great as in the $Al_xGa_{1-x}As/Ge$ system.

In the above, there have been described the cases where the single two-dimensional carrier (two-dimensional electron gas or two-dimensional hole gas) appearing in the single heterojunction is employed as the base. However, the HBT need not always be formed of the single heterojunction, but the same applies to a system having a multiple heterostructure of two or more heterojunctions.

As a structure which enlarges the current gain $h_{FE}$ still more, in the emitter layer 35 in Fig. 3, the band gap on the side of an emitter electrode is made greater, in other words, the energy gap $\Delta E_c$ of the conduction band is made greater on the side of the emitter electrode, whereby $h_{FE}$ can be rendered still greater.

The purpose of the present invention described above can be summed up as follows:

(1) Reduction in the size of a base region is possible, and the transit time of minority carriers in the base region shortens, so that a raised operating speed can be achieved.

(2) A high-density two-dimensional carrier (two-dimensional electron gas or two-dimensional hole gas) is formed at an interface on a collector side as the base region, whereby the resistance of the base region becomes low, and a raised operating speed can be achieved.

(3) This two-dimensional carrier is formed at the aforementioned heterojunction interface in such a way that, when in a heterojunction formed of a first semiconductor and a second semiconductor, the second semiconductor is smaller in the electron affinity as compared with the first semiconductor, the second semiconductor is doped with an n-type impurity, or that, when the second semiconductor is greater than the first semiconductor in the sum between the electron affinity and the energy band gap, the former is doped with a p-type impurity.

**Brief Description of the Drawings:**

Fig. 1 is a diagram showing the structural section and band structure of a prior-art heterojunction bipolar transistor.

Fig. 2 is a diagram showing the structural section and band structure of a prior-art heterojunction bipolar transistor.

Fig. 3 is a diagram showing the structural section and band structure of a heterojunction bipolar transistor according to the present invention.

Fig. 4 is a diagram showing the structural section and band structure of a heterojunction bipolar transistor according to the present invention.

Fig. 5 is a diagram showing Example 1 of the present invention.

Fig. 6 is a diagram showing Example 2 of the present invention.

Fig. 7 is a diagram showing Example 3 of the present invention.

Fig. 8 is a diagram showing Example 4 of the present invention.

Fig. 9 is a diagram showing a band structure in the case where a base region is put into a superlattice structure in Example 4 of the present invention.

Fig. 10 is a diagram showing Example 5 of the present invention.

Fig. 11 is a diagram showing Example 6 of the present invention.

Fig. 12 is a diagram showing Example 7 of the present invention.

Fig. 13 is a diagram showing Example 8 of the present invention.

Fig. 14 is a diagram showing Example 9 of the present invention.

Fig. 15 is a diagram showing Example 10 of the present invention.

Fig. 16 is a diagram showing a prior-art inverter structure.

Fig. 17 is a diagram showing Example 11 of the present invention.

Fig. 18 is a diagram showing symbols expressive of elements which are used in Example 11 of the present invention.

Fig. 19 is a diagram showing basic inverter circuits in Example 11 of the present invention.

Fig. 20 is a diagram showing basic inverter circuits in Example 11 of the present invention.

Fig. 21 is a diagram showing gate circuits in Example 11 of the present invention.

**Best Mode for Carrying Out the Invention:**

Example 1:

A p-n-p type HBT which employs the heterojunction between $Al_xGa_{1-x}As$ and GaAs will be first described.

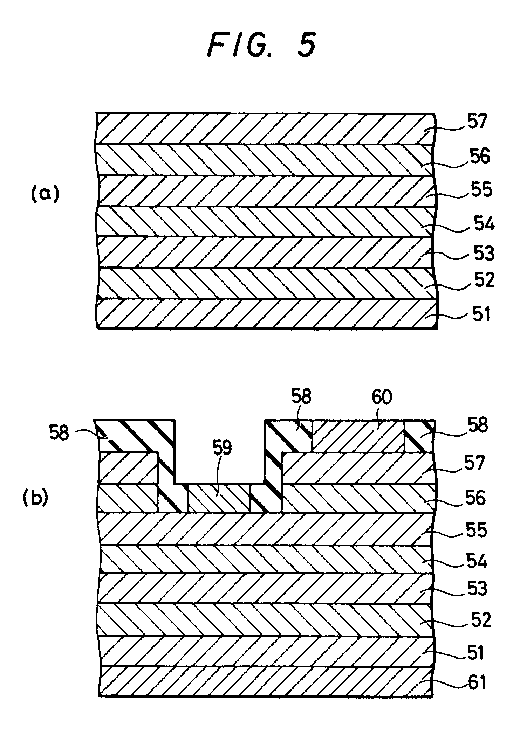

The principal steps of an example in the case of disposing a collector on a rear surface are illustrated in Figs. 5(a) and 5(b).

On a $p^+$-type GaAs substrate (concentration: $2 \times 10^{19}$ cm$^{-3}$) 51 employing Ge as a p-type dopant, the following layers were epitaxially grown in succession [Fig. 5(a)] by the use of an MBE (molecular-beam epitaxy) apparatus and under the condition of a substrate temperature of 650 °C; a $p^+$-type GaAs layer (concentration: $1 \times 10^{19}$ cm$^{-3}$, thickness: 500 nm) 52 employing Be as a p-type dopant, a $p^-$-type GaAs layer (concentration: $1 \times 10^{15}$ cm$^{-3}$, thickness: 300 nm) 53, an undoped $AlGa_{1-x}As$ layer (x = 0.35 and x is usually from approximately 0.1 to 0.45, thickness: 5 nm) 54, an $n^+$-type $Al_xGa_{1-x}As$ layer (x = 0.3,

6

concentration: $5 \times 10^{18}$ cm$^{-3}$, thickness: 15 nm) 55 employing Si as an n-type dopant, a p$^+$-type Al$_x$Ga$_{1-x}$As layer (concentration: $2 \times 10^{19}$ cm$^{-3}$, thickness: 300 nm) 56 employing Be as a p-type dopant, and a p$^+$-type GaAs layer (concentration: $2 \times 10^{19}$ cm$^{-3}$, thickness: 200 nm) 57 employing Be as a p-type dopant. The p$^+$-type GaAs layer 57 is provided in order to facilitate forming an ohmic contact with a lead-out metal, and it is not essential to transistor operations.

The undoped AlGaAs layer 54 is inserted for the purpose of preventing the mobility of a two-dimensional electron gas from deteriorating at a hetero-interface.

Subsequently, in order to mount a base lead-out portion 59, a pattern was formed using a conventional photolithographic process, and only the two layers of the p$^+$-type GaAs layer 57 and p$^+$-type Al$_x$Ga$_{1-x}$As layer 56 were formed with a contact hole by chemical etching. For inter-layer separation, an SiO$_2$ film 58 (300 nm) was formed by CVD and was thereafter etched by a photolithographic process. Au/Ni/AuGe were evaporated in the base lead-out portion 59, and were formed into the ohmic contact by annealing at 450 °C for 5 minutes. Further, Au/Cr were evaporated in an emitter lead-out portion 60 by a similar method. Besides, Au/Cr were evaporated on the rear surface as a collector lead-out portion 61. They were formed into an ohmic contact by annealing at 300 °C for 10 minutes [Fig. 5(b)]. Isolation was carried out at the last step by mesa-etching.

Although, in the present example, the crystal growth was performed using Be as the p-type dopant, Mg or Ge is of course usable.

Owing to the above steps, the high performance of an h$_{FE}$ of 1000 and a cutoff frequency f$_T$ of 30 GHz was attained with a device in which the size of an emitter region was 1.6 x 5 $\mu$m$^2$.

Although the present example illustrated the case of employing the p$^+$-type AlGa$_{1-x}$As layer 56, this layer is not indispensable to bipolar transistor operations but may well be replaced with a p$^+$-type GaAs layer. On that occasion, in forming a base, the GaAs layer is selectively etched and removed with gases CCl$_2$F$_2$/He so as to expose the n$^+$-type AlGaAs layer 55, and a base electrode metal is evaporated and lifted off, whereby the base region can also be formed.


Example 2:

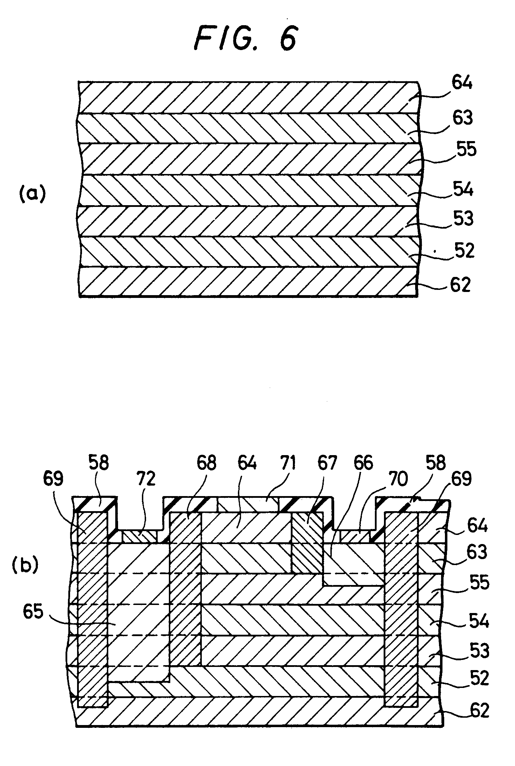

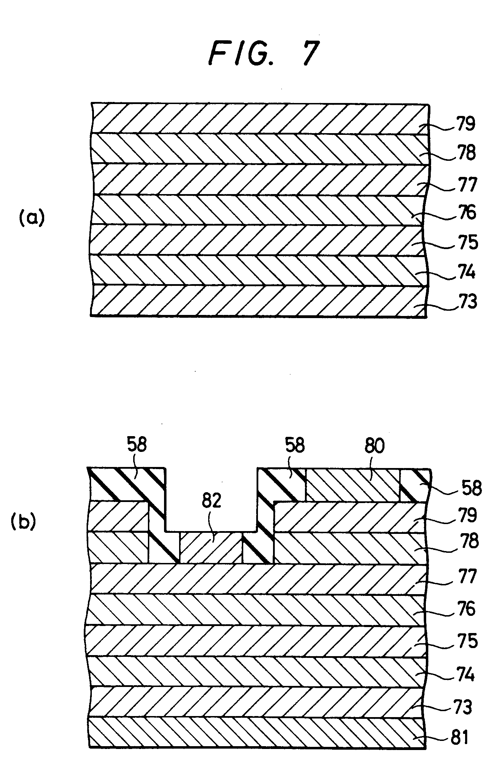

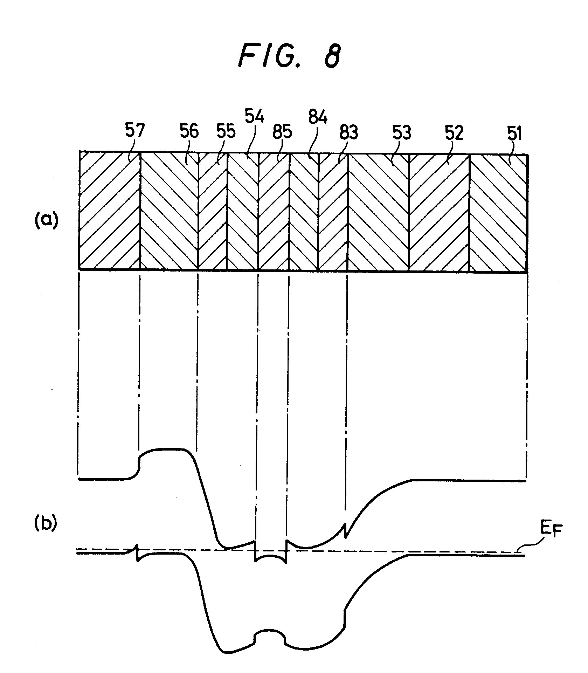

The principal steps of an example in the case of a planar type HBT provided with a collector lead-out portion on a front surface are illustrated in Figs. 6(a) and 6(b). Since the present example is quite the same as Example 1 except a substrate, the crystal specifications of an emitter layer, the formation of the collector lead-out portion and the formation of a base lead-out portion, only these different parts will be elucidated.

The substrate employed was a semi-insulating GaAs substrate 62, and the specifications of crystal growth from a p$^+$-type GaAs layer 52 to an n$^+$-type Al$_x$Ga$_{1-x}$As layer 55 were the same as in Example 1.

The emitter layer was grown continuously to the base layer 55 by MBE. A p$^+$-type Al$_x$Ga$_{1-x}$As layer (concentration: $5 \times 10^{18}$ cm$^{-3}$, thickness: 100 nm) 63 and a p$^+$-type GaAs layer (concentration: $5 \times 10^{18}$ cm$^{-3}$, thickness: 400 nm) 64 differed from Example 1 only in the thicknesses and doping levels of the respective layers.

Subsequently, a pattern for the collector lead-out portion 65 was formed using a conventional photolithographic process. Here, the p$^+$-type GaAs layer 64 was removed by the selective etching of GaAs employing a dry process. The collector lead-out portion 65 of the p$^+$-type was formed by ion implantation and annealing. This ion implantation is carried out so that the maximum depth down to which implanted ions exist may substantially agree with the depth (~400 nm) of the collector layer 52, and it is important to inverse the base layer 55 into the p-type. In case of using Mg$^+$ as a p-type impurity, an implantation energy is set at about 300 keV and a dose at $5 \times 10^{13}$ cm$^{-2}$. Apart from Mg, Be may well be used. In this case, the implantation energy needs to be set at approximately 100 keV. Thereafter, annealing for activating the implanted ions was conducted. The conditions of the annealing were 800 °C and 20 minutes.

Next, the implantation of n-type ions for forming the base lead-out portion 66 was carried out similarly to the process for forming the collector lead-out portion 65. On this occasion, the ion implantation was performed so that the maximum depth of implanted ions might become approximately 115 nm. In case of using Si$^+$ as an n-type impurity, the implantation energy was about 130 keV, and the dose was $1 \times 10^{14}$ cm$^{-2}$.

Next, in order to separate an emitter electrode 71 and the base lead-out portion 66, ion implantation was carried out to form a damaged layer 67.

This ion implantation is intended to diminish a parasitic capacitance owing to the formation of the damaged layer 67.

Accordingly, the implantation depth may be such that damages by the ion implantation extend to a depletion layer on the emitter side. The thickness of the depletion layer is several nm for the aforementioned emitter concentration, so that the depth of the damaged layer may be approximately 400 nm. As ion species, any may be used as long as its diffusion coefficient in the crystal is small, and any of $C^+$, $O^+$, $Ar^+$ etc. usually and often used may be employed. This ion implantation is carried out so as to surround an operation region. As the dose and implantation energy in the case of employing $C^+$, approximately $1 \times 10^{13}$ cm$^{-2}$ and 1200 keV are the most suitable respectively.

Next, ion implantation was performed for separating the operation region from the collector lead-out portion 65. The corresponding ion-implanted portion 68 is similar to the case of the separation of the base lead-out portion 66, and the same species of ions can be used. The depth needs to reach the lower side of the base layer 55, and in case of employing $C^+$, the ion implantation is carried out under conditions of 300 keV and $1 \times 10^{13}$ cm$^{-2}$.

Lastly, electrodes were formed on the front surface of the device by the use of a lift-off process. To this end, $SiO_2$ (300 nm) was formed on the front surface of the device by CVD. First, the base electrode 70 was formed on the GaAs layer turned into the n-type by ion implantation into the base lead-out portion 66. Multilayer metal of Au/Ni/AuGe was used as the material of the electrode. After a pattern was formed by the lift-off process, an ohmic contact was formed by annealing at 450 °C for 5 minutes.

Subsequently, the emitter electrode 71 and the collector electrode 72 were respectively formed on the p-type GaAs layer of an emitter portion and on the p-type $Al_xGa_{1-x}As$ layer of the collector lead-out portion 65. Au/Cr was used as the material of the electrodes. Annealing conditions for forming ohmic contacts were 300 °C and 10 minutes.

Further, an ion-implanted portion 69 reaching the substrate 62 was provided for isolation. Likewise to the foregoing, this portion is similar to the case of the separation of the base lead-out portion 66, and the same species of ions can be used. In case of employing $C^+$, ion implantation is carried out under conditions of 350 keV and $2 \times 10^{13}$ cm$^{-2}$.

As thus far described, according to the present example, the bipolar transistor of the planar type heterojunction can be fabricated, so that a higher density of integration becomes possible. Besides, the operation region is electrically separated from the base lead-out portion and the collector lead-out portion, so that the device exhibiting a small parasitic capacitance and being capable of fast operation can be formed.

Example 3:

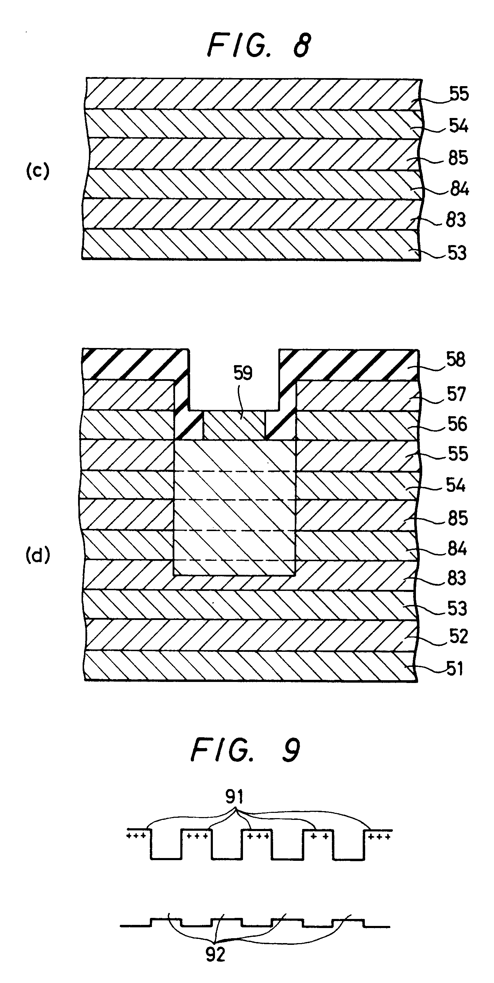

Now, the third example of the present invention will be described with reference to Figs. 7(a) and 7(b). Whereas Example 1 has illustrated the case of the p-n-p type heterojunction bipolar transistor, the present example illustrates the case of the n-p-n type.

Accordingly, although crystal specifications and metals to ohmically contact with an emitter, a base and a collector are different, methods of leading out the emitter, the base and the collector are the same, and only the different points will be elucidated below.

On an $n^+$-type GaAs substrate (concentration: $2 \times 10^{18}$ cm$^{-3}$) 73 employing Si as an n-type dopant, the following layers were epitaxially grown in succession by the use of an MBE apparatus; an $n^+$-type GaAs layer (Si concentration: $2 \times 10^{18}$ cm$^{-3}$, thickness: 500 nm) 74, an $n^-$-type GaAs layer (Si concentration: $2 \times 10^{14}$ cm$^{-3}$, thickness: 300 nm) 75, an undoped $Al_xGa_{1-x}As$ layer (thickness: 5 nm) 76, a $p^+$-type $Al_xGa_{1-x}As$ layer (Be concentration: $1 \times 10^{18}$ cm$^{-3}$, thickness: 15 nm) 77, an $n^+$-type $Al_xGa_{1-x}As$ layer (Si concentration: $1 \times 10^{18}$ cm$^{-3}$, thickness: 300 nm) 78, and an $n^+$-type GaAs layer (Si concentration: $1 \times 10^{18}$ cm$^{-3}$, thickness: 200 nm) 79.

Ohmic contacts were first formed for an emitter lead-out metal 80 and a collector lead-out metal 81 by the use of Au/Ni/AuGe. The materials Au/Ni/AuGe were alloyed at 450 °C for 5 minutes. Thereafter, for a base lead-out metal 82, Au/Cr were evaporated and annealed to form an ohmic contact. The materials Au/Cr were annealed under conditions of 300 °C and 10 minutes. In this regard, the order of the steps of the respective ohmic contacts of the emitter, base and collector needs to be determined by paying attention to the refractoriness of metals employed.

Fabricating the n-p-n type heterojunction bipolar transistor of the present example into the planar type as in Example 2 is possible in such a way that the implantation ions for the collector and base lead-out portions and the energy levels and doses thereof are changed into proper ones by taking note of the reversal of the p-type and the n-type.

Example 4:

Now, Example 4 of the present invention will be described with reference to Figs. 8(a) - 8(b). Although Example 1 is characterized by having the single heterostructure in the base region of the p-n-p heterojunction bipolar transistor, the present example is characterized by having two heterostructures in order to render the resistance of the base region still lower. The difference from Example 1 consists merely in this base region, and only the different points will be explained.

In the crystal growth, the $p^-$-type GaAs layer 53 was followed by an $n^+$-type $Al_xGa_{1-x}As$ layer (Si concentration: $2 \times 10^{18}$ cm$^{-3}$, thickness: 15 nm) 83, an undoped $Al_xGa_{1-x}As$ layer (thickness: 5 nm) 84 and an undoped GaAs layer (thickness: 20 nm) 85, and the portion of and above the undoped $Al_xGa_{1-x}As$ layer (thickness: 5 nm) 54 was the same as in Example 1 [Fig. 8(c)]. Figs. 8(a) and 8(b) show the cross sectional structure and band structure of the double-heterojunction base bipolar transistor of the present example, respectively. The base lead-out from the base region was the same as in Example 1 in that a pattern was formed using the photolithographic process, whereupon a contact hole was formed. However, a base lead-in portion was formed by ion implantation and annealing [Fig. 8(d)]. In case of Si ions, the implantation energy is about 50 keV, and the dose is approximately $1 \times 10^{13}$ cm$^{-2}$. When a lamp annealing method is used, the annealing conditions are 900 °C and 30 seconds. This lead-in portion is effective to prevent the mobility of the two-dimensional electron gas of the base from deteriorating.

The subsequent steps were the same as in Example 1. The double-heterojunction bipolar transistor of the present example can be applied to the planar type and the n-p-n type as in the second and third examples by considering the points of which note was taken for the base region in the present example.

Although, in the present example, the base region was formed with the two heterostructures, it can also be put into a superlattice structure as shown in Fig. 9. More specifically, $Al_xGa_{1-x}As$ (x ~ 0.3) films 91 each being 8 nm thick and containing Si at $2 \times 10^{18}$ cm$^{-3}$ and undoped GaAs films 92 each being 5 nm thick were periodically arrayed as illustrated in Fig. 9. With such a base structure, the base width enlarges, but there is the effect that the base resistance lowers.

Example 5:

Although the examples thus far described have referred to the HBT's employing the heterojunctions of $Al_xGa_{1-x}As$ and GaAs, substances to be used are not necessarily restricted thereto. In the present example, there will be explained a case of employing the heterojunction of $Al_xGa_{1-x}As$ ($0 \leq x \leq 1$) and Ge.

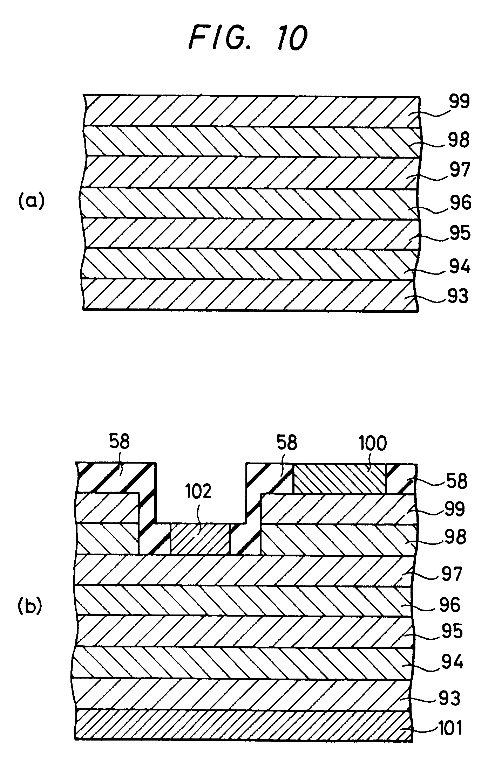

Figs. 10(a) and 10(b) illustrate the principal steps of an n-p-n type HBT in which the Al composition ratio of AlGaAs, x = 0 holds, in other words, which is made of GaAs and Ge. The principal steps are similar to those of Example 3 except that the crystal growth and an ohmic metal for Ge are different. Accordingly, only the different parts will be elucidated. On an $n^+$-type Ge substrate (concentration: $2 \times 10^{18}$ cm$^{-3}$) 93 employing phosphorus P as an n-type dopant, the following layers were successively grown by an epitaxial growth method with an MBE apparatus; an $n^+$-type Ge layer (P concentration: $2 \times 10^{18}$ cm$^{-3}$, thickness: 500 nm) 94, an $n^-$-type Ge layer (P concentration: $2 \times 10^{14}$ cm$^{-3}$, thickness: 300 nm) 95, an undoped Ge layer (thickness: 5 nm) 96, a $p^+$-type Ge layer (B concentration: $1 \times 10^{18}$ cm$^{-3}$, thickness: 15 nm) 97, an $n^+$-type $Ga_{1-x}As$ layer (Si concentration: $1 \times 10^{18}$ cm$^{-3}$, thickness: 300 nm) 98, and an $n^+$-type GaAs layer (Si concentration: $1 \times 10^{18}$ cm$^{-3}$, thickness: 200 nm) 99.

A contact hole for forming a base lead-out portion was provided as in Example 3, whereupon $SiO_2$ 58 was deposited. Emitter lead-out metals Au/Ni/AuGe 100 for forming the ohmic contact of the emitter layer, $n^+$-type GaAs 99 were evaporated and were alloyed at 450 °C for 5 minutes. Subsequently, a contact hole for a base lead-out portion was similarly provided. Thereafter, an ohmic contact metal 102 for the base layer and an ohmic contact metal 101 for the collector layer were evaporated and were alloyed at 200 °C for 10 minutes. Then, the process for forming the n-p-n type heterojunction base HBT made of $Al_xGa_{1-x}As/Ge$ ended.

Example 6:

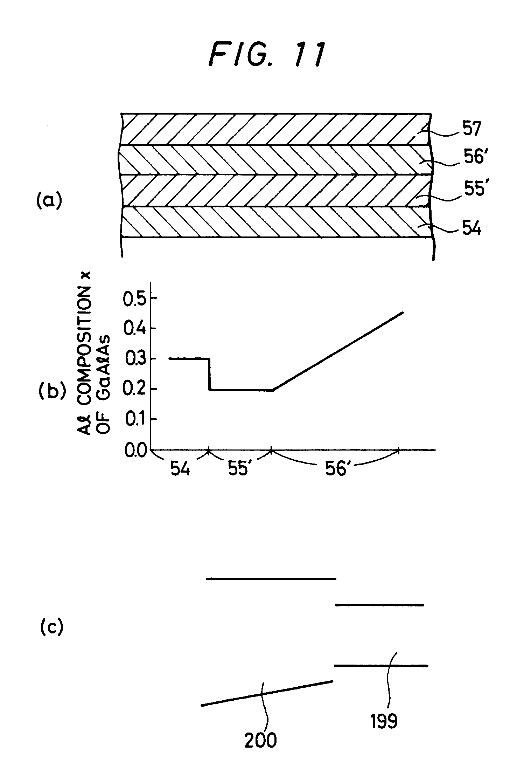

The example of the present invention having the p-n-p type which can render the current gain $h_{FE}$ high is illustrated in Figs. 11(a) and 11(b).

The portion of the $n^+$-type $Al_xGa_{1-x}As$ layer 55 and $P^+$-type $Al_xGa_{1-x}As$ layer 56 in Example 1 was changed into AlGaAs layers which had Al composition ratios as indicated in Fig. 11(b). The other manufacturing steps were the same as in Example 1.

The composition ratio x of the $p^+$-type $Al_xGa_{1-x}As$ layer 56' is made greater on the emitter electrode side as illustrated in Fig. 11(b), whereby $h_{FE}$ can be increased more. The $n^+$-type $Al_xGa_{1-x}As$ layer 55' was formed at x = 0.2. This serves chiefly for improving the crystallinity of AlGaAs. Although, in the example, the Al composition ratio x of the $p^+$-type $Al_xGa_{1-x}As$ layer 56' varied rectilinearly [Fig. 11(b)], this is not always necessary, but the Al composition ratio may be smaller on the side of the n$^+$-type AlGaAs 55' and greater on the side of the emitter electrode (p$^+$-type AlGaAs 57).

It is also effective in [Example 5] of the present invention concerning the n-p-n type that the current gain is increased by varying the Al composition ratio of the $Al_xGa_{1-x}As$ of the emitter layer in this manner. This measure is also applicable to another heterojunction system. In the case of the n-p-n type, however, the energy gap of the valence band needs to be wider on the emitter electrode side, unlike the case of Example 6. The situation of the band gaps in this case is shown in Fig. 11(c). As seen from the figure, the emitter layer 200 is designed so as to have the wider band gap on the emitter side with respect to the material of the base layer 199 for storing two-dimensional holes.

Although the above examples were explained as to the semiconductor devices constructed of the $Al_xGa_{1-x}As$ -GaAs system and the $Al_xGa_{1-x}As$-Ge system, materials constructing different heterojunctions are also appropriate.

They are, for instance, $AlGa_{1-y}As-Al_xGa_{1-x}AsGaAs-AlGaAsP$, InP-InGaAsP, InP-InGaAs, InAs-GaAsSb, CdTe-InSb, and GaSb-InAs.

Next, Examples 7 thru 10 will elucidate heterojunction bipolar transistor structures each employing a two-dimensional carrier for a base layer, which especially realize ultrahigh speeds at low temperatures of or below 77 K.

Example 7:

It has been experimentally known that a two-dimensional electron gas layer stored at the interface of a single heterojunction defined by n-type AlGaAs and undoped GaAs exhibits a very high mobility (about 117,000 $cm^2/v \cdot s$) at the temperature of liquid nitrogen (77 K) (refer, for example, to Japanese Journal of Applied Physics, 20 (1981) L455). In the system of such a high mobility, the sheet resistance $\zeta s^{2DEG}$ of the two-dimensional electron gas layer is approximately 100 $\Omega/_\square$, which is about 1/40 of the base sheet resistance of the prior-art n-p-n type GaAs/AlGaAs HBT. That is, when the two-dimensional electron gas layer at 77 K is employed as a base layer, an HBT having as low a base resistance as approximately 1/40 of that of the prior-art HBT can be realized.

In addition, with a structure wherein only a GaAs layer is doped with an impurity by the use of an AlGaAs/GaAs superlattice [for example, a literature 'Japanese Journal of Applied Physics,' 20 (1983) L627], the same effect as that of an AlGaAs emitter layer free from carrier freezing-out and doped with an impurity can be produced.

That is, in the HBT, when the AlGaAs/GaAs superlattice in which GaAs is doped with the impurity and AlGaAs is doped with no impurity is employed as an emitter layer instead of the AlGaAs emitter layer doped with the impurity, the freezing-out of carriers at 77 K hardly takes place.

With the above two items taken into account, the superlattice structure was possessed in the emitter layer (and the base layer) and the two-dimensional electron gas was employed for the base layer.

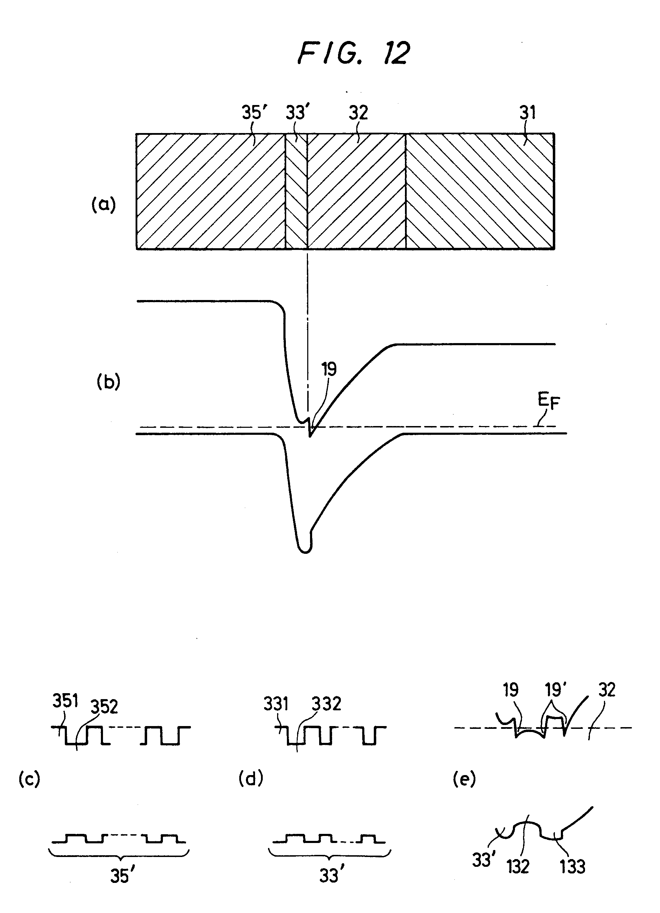

Figs. 12(a) - 12(d) illustrate a semiconductor structure (Fig. 12(a)) and its band structures (b), (c) and (d) for elucidating the operating principle of an n-p-n type transistor in the present example.

Figs. 12(a) and 12(b) show a cross sectional view (a) of the major portions of the transistor and a corresponding energy band diagram (b), respectively, and Figs. 12(c) and 12(d) show supplementary band diagrams.

Numeral 31 designates a collector layer, which is p-type GaAs at an impurity level of $\sim 10^{19}$ $cm^{-3}$ usually having Be or Mg as a p-type impurity. Numeral 32 designates a p$^-$-type (approximately $10^{15}$ $cm^{-3}$) GaAs layer, the thickness of which is usually 300 nm or so. The point of the present example consists in an n-type AlGaAs/GaAs superlattice layer 33' and a p-type AlGaAs/GaAs superlattice layer 35'. Here, the n-type superlattice layer 33' is intended to mean a superlattice structure in which GaAs 332 doped into the n-type and AlGaAs layers 331 not intentionally doped with any impurity or AlGaAs layers 331 usually having a doping level of or below $10^{15}$ $cm^{-3}$ are alternately stacked.

Ordinarily, the mixing ratio x of Al is often set between 0.15 and 0.45. The energy band diagram is shown in Fig. 12(d). It is ordinarily possible to vary the thickness of the GaAs layer 332 or the AlGaAs layer 331 in a wide range of 0,5 nm - 10 nm. It is also important that the collector side of the n-type superlattice layer 33' is formed by the AlGaAs layer 331.

On the other hand, the p-type superlattice layer 35' indicates a superlattice structure in which, as shown in Fig. 12(c), GaAs 352 doped into the p-type and AlGaAs layers 351 not intentionally doped with any impurity or AlGaAs layers 351 usually having a doping level of or below $10^{15}$ $cm^{-3}$ are alternately stacked. Also in this case, the thickness of the GaAs layer 352 or the AlGaAs layer 351 is orinarily 0,5 nm - 10 nm.

In this case, it is also possible to increase the current gain $h_{FE}$ in such a way that the mixing ratio of Al is made greater in the AlGaAs layer 351 remoter from the n-type superlattice.

The most important reason for introducing such superlattice structures is that, when the p-type/n-type impurities are properly selected, the donor and acceptor levels of the impurities of the GaAs are shallow, so the freezing-out of carriers does not occur at the low temperature of approximately 77 K.

The expression 'superlattice' here signifies the superlattice in which the carriers spread all over. That is, a well type potential established by the AlGaAs/GaAs is not localized to the GaAs side.

In the present example, a two-dimensional electron gas 19 stored at the interface of the heterojunction between the n-type superlattice layer 33' and the p⁻-type collector layer 32 is employed as a base layer. As seen from a band diagram shown in Fig. 12(e), however, it is also allowed to form an n-type AlGaAs/GaAs superlattice layer 133 and an undoped GaAs layer 132 on the p⁻-type GaAs layer 32 and to further form the n-type AlGaAs/GaAs superlattice layer 33'.

When two or more two-dimensional electron gas layers 19, 19' are formed in this manner, the base resistance can be decreased to half.

For the purpose of shortening the transit time of holes in the base, at the p-n junction between the p-type superlattice layer 35' and the n-type superlattice layer 33', the n-type superlattice layer 33' is depleted except the part of the two-dimensional electron gas, and also the p-type superlattice layer 35' is partly depleted. It is common that a neutral region where the carriers exist is prevented from being formed in the n-type superlattice.

Since the skip $\Delta E_c$ 9 of the energy levels of the conduction bands of the p⁻-type GaAs layer 32, in which the two-dimensional electron gas being the base layer exists, and the n-type AlGaAs/GaAs superlattice layer 33' is as great as 300 meV (the difference between the electron affinities of the superlattice and the GaAs), the high current gain $h_{FE}$ increases more. Besides, since the two-dimensional electron gas is as very thin as approximately 10 nm, the transit time of the hole in the base becomes negligible, and the restriction of the base transit time due to which the prior-art p-n-p type HBT has the operating speed rendered extremely low can be eliminated.

Example 8:

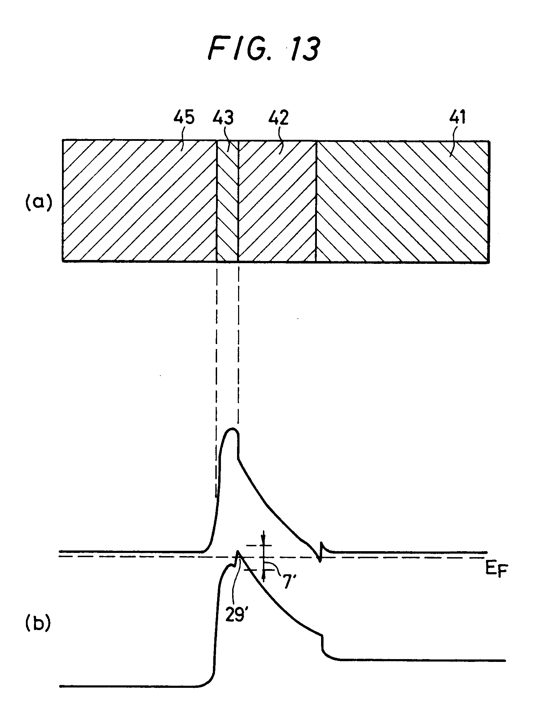

An example employing two-dimensional holes as a base layer will be described with reference to Figs. 13(a) and 13(b).

Fig. 13(a) shows the sectional structure of the major portions of a novel HBT, while Fig. 13(b) is a corresponding energy band diagram. On a collector layer 41 of n⁺-type GaAs containing Si at approximately $5 \times 10^{19}$ cm⁻³, a collector layer 42 of n⁻-type Ge containing antimony Sb at approximately $10^{14}$ cm⁻³ is formed to approximately 300 nm, GaAs 43 containing Be at $5 \times 10^{18}$ cm⁻³ is formed to approximately 20 nm and an n-type AlGaAs/GaAs superlattice 45 being an emitter layer is formed to approximately 300 nm. Here, the impurity doping level of the n-type superlattice is on the order of $2 \times 10^{18}$ cm⁻³.

As to GaAs and Ge, on account of the discontinuity $\Delta E_v$ 7' of the valence band gaps thereof, some of free electrons in the p-type GaAs layer 43 are stored on the Ge side 42 to form a two-dimensional hole gas 29'. At the room temperature, the two-dimensional hole gas layer has a mobility of approximately 3,000 cm²/v•s and a sheet concentration of approximately $2 \times 10^{12}$ cm⁻².

Meanwhile, some of the free holes of the p-type GaAs layer 43 are transferred to the n-type superlattice 45 to form a spacial charge layer gas.

At the low temperature of 77 K, the mobility of the two-dimensional hole gas becomes as high as 50,000 cm²/v•s, and the sheet resistance becomes approximately 20 $\Omega/_\square$ to realize a very low base resistance.

This example employing the two-dimensional hole gas as the base layer can be operated fast at 77 K even when the n-type superlattice 45 is replaced with n-type GaAs.

Using a plurality of two-dimensional hole gas layers for the base as described before, the base resistance can be further lowered.

Example 9:

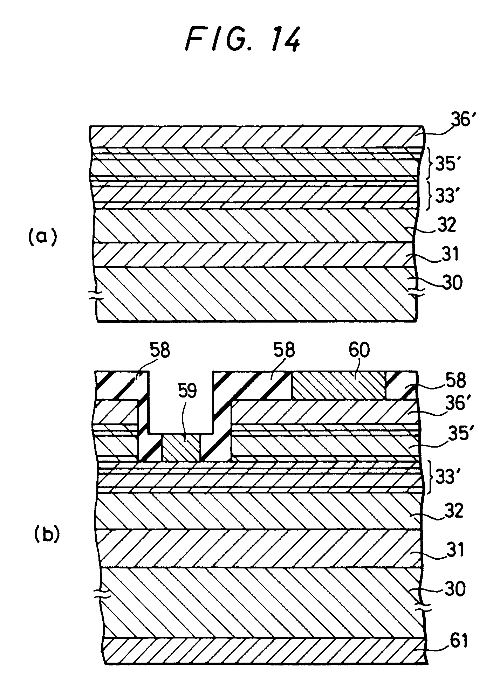

The principal manufacturing steps of a device in the case of providing a collector layer on the rear side of a substrate are illustrated in Fig. 14.

On a p⁺-type GaAs substrate (concentration: $2 \times 10^{19}$ cm⁻³) 30 employing Ge as a p-type dopant, the following layers were formed by the MBE (molecular-beam epitaxy) and at a substrate temperature of 650 °C; a p⁺-type GaAs layer (concentration: $1 \times 10^{19}$ cm⁻³, thickness: 500 nm) 31 employing Be as a p-type dopant, an undoped GaAs layer (resulting in the $p^-$-type at $10^{15}$ cm$^{-3}$) 32 having a thickness of 300 nm, an n-type AlGaAs/GaAs superlattice 33' having a thickness of 20 nm [undoped Al$_x$Ga$_{1-x}$As 5 nm thick/n-type GaAs 2,5 nm thick/undoped Al$_x$Ga$_{1-x}$As 2,5 nm thick/n-type GaAs 2,5 nm thick/undoped Al$_x$Ga$_{1-x}$As 2,5 nm thick; Al mixing ratio x of ~0.3, Si impurity concentration of 4 x $10^{17}$ cm$^{-3}$], a p-type AlGaAs/GaAs superlattice 35' having a thickness of 200 nm [superlattice having forty layers of undoped Al$_x$Ga$_{1-x}$As 2,5 nm thick/p-type GaAs 2,5 nm thick; x of ~0.3, Be concentration of approximately 1 x $10^{19}$ cm$^{-3}$], and a p-type GaAs layer 36' containing Be at 1 x $10^{19}$ cm$^{-3}$ and having a thickness of 200 nm [Fig. 14(a)].

Subsequently, an SiO$_2$ layer 58 was formed on the whole surface to a thickness of 300 nm by CVD, the p-type GaAs layer 36' and the p-type superlattice layer 35' were removed by etching, and a base electrode 59 was formed using a conventional photolithographic process. AuGe/Ni/Au were used for the base electrode 59. Next, they were alloyed in an H$_2$ atmosphere at 450 °C for 3 minutes. Likewise, Cr/Au were evaporated on the whole rear surface for the collector electrode 61, and Cr/Au were deposited on the p-type GaAs layer 36' for an emitter electrode 60.

By alloying at 300 °C for 10 minutes, ohmic contacts were formed [Fig. 14(b)].

At the next step, mesa-etching for isolation was carried out.

In the present example, the Al mixing ratio x of the AlGaAs of the p-type superlattice 35' was 0.3 and uniform. In this connection, the current gain h$_{FE}$ can also be increased by giving the Al mixing ratio a gradient in which this ratio is 0.2 on the side of the n-type superlattice and is 0.40 on the side of the p-type GaAs 36.

As is common in planar HBT's, it is also possible to form an epitaxial layer on a semi-insulator GaAs substrate so as to form a planar collector electrode.

Example 10:

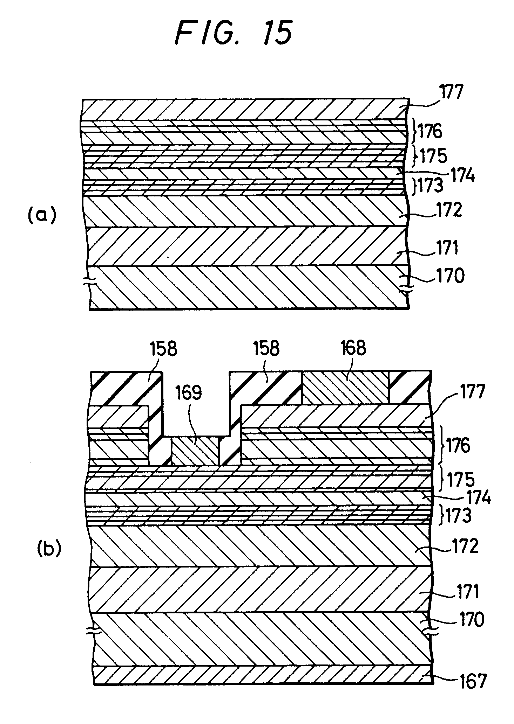

An example in the case of employing a two-dimensional hole gas as a base layer is illustrated in Figs. 15(a) and 15(b).

On an n-type GaAs substrate 170 containing Si at 2 x $10^{18}$ cm$^{-3}$, an n$^+$-type GaAs layer 171 containing Si at 2 x $10^{18}$ cm$^{-3}$ was formed as a collector layer to a thickness of 500 nm using MBE. Subsequently, a GaAs layer 172 containing Si at 1 x $10^{14}$ cm$^{-3}$ was formed to 300 nm.

Next, a p-type AlGaAs/GaAs superlattice 173 was formed to 20 nm [undoped Al$_x$Ga$_{1-x}$As 5 nm thick/p-type GaAs 2,5 nm thick / undoped Al$_x$Ga$_{1-x}$As 2,5 nm thick/p-type GaAs 2,5 nm thick/undoped Al$_x$Ga$_{1-x}$As 2,5 nm thick/p-type GaAs 2,5 nm thick/undoped Al$_x$Ga$_{1-x}$As 2,5 nm thick; x being ~0.45, the p-type GaAs containing Be as a p-type impurity at 1 x $10^{19}$ cm$^{-3}$], and a GaAs layer 174 containing Si at 1 x $10^{14}$ cm$^{-3}$ and having a thickness of 5 nm was formed. Thereafter, a p-type AlGaAs/GaAs superlattice 175 similar to the above superlattice 173 was formed to 30 nm (superlattice having six layers of undoped Al$_x$Ga$_{1-x}$As 2,5 nm thick/p-type GaAs 2,5nm thick; x being ~0.45, the p-type GaAs containing Be as a p-type impurity at 1 x $10^{19}$ cm$^{-3}$). Further, an n-type AlGaAs/GaAs superlattice 176 was formed to 200 nm (superlattice formed of twenty undoped Al$_x$Ga$_{1-x}$As 5 nm thick/n-type GaAs 5 nm thick; x being ~0.4, the n-type GaAs containing Si at 3 x $10^{18}$ cm$^{-3}$). Further, an n$^+$-type GaAs layer 177 for facilitating the formation of an ohmic contact (containing an impurity Si at 3 x $10^{18}$ cm$^{-3}$) was formed to 200 nm [Fig. 15(a)].

After an SiO$_2$ film 158 was formed on the whole front surface to 300 nm by the CVD, AuGe/Ni/Au were vacuum-evaporated on the rear surface for a collector electrode 167, and AuGe/Ni/Au were evaporated for an emitter electrode 168 in contact with the n$^+$-type GaAs layer 177 by the use of conventional lithography. Subsequently, alloying at 400 °C for 3 minutes was carried out in an H$_2$ atmosphere, to obtain ohmic contacts.

Next, the n$^+$-type GaAs layer 177 and the n-type superlattice 176 were removed by etching, and a base electrode 169 was formed by a conventional method. For the base electrode, Cr/Au were used and were heated at 300 °C for 10 minutes so as to be alloyed.

Although the above examples 7 - 10 were explained as to the AlGaAs/GaAs heterojunction system, the invention is also applicable to different heterojunction systems.

They are, for example, InP/InGaAsP, GaAs/AlGaAsP, InP/InGaAs, InAs/GaAsSb, CbTe/InSb, and GaSb/InAs.

In any of Examples 7 - 10, a heterojunction bipolar transistor employing at least one two-dimensional carrier as a base layer has been formed using a semiconductor which forms a shallow impurity level (donor or acceptor), and a superlattice structure in which only the semiconductor forming the shallow impurity level is doped with an impurity. It has therefore become possible to prevent the carrier from being frozen out at the low temperature of 77 K and to attain a low base resistance equal to approximately 1/40 of the base resistance of the prior-art HBT, owing to the high mobility of the two-dimensional carrier at 77 K.

Example 11:

As stated before, the bipolar transistor employing the two-dimensional electron gas has such features (1) that the base resistance can be rendered approximately 1/5 of the value of the prior art (as low as 1/50 at 77 K), (2) that since the thickness of the base layer (the thickness of the two-dimensional electron gas) is approximately 10 nm, the base transit time of minority carriers is, in effect, negligible, and (3) that since $\Delta E_c$ can be rendered greater as compared with the room temperature in the case of GaAs/AlGaAs, a high current gain can be expected.

The base layer need not always be the single heterojunction, but two two-dimensional carriers may well be employed as the base layer, and the concentration of the two-dimensional carrier may well be increased by employing a quantum well structure. For the purpose of performing a high-speed operation at 77 K, a semiconductor layer which forms a deep (~50 meV) impurity level does not undergo the freezing-out of the carriers owing to the use of a superlattice structure in which only a semiconductor having a shallow impurity level is doped with an impurity, so that the HBT operation at 77 K becomes possible. The transistor as described above shall be generally termed the 'hetero-bipolar transistor employing the two-dimensional electron or hole gas.'

With the heterojunction system as stated above, however, an operation as a field-effect transistor is also permitted by running the two-dimensional electron gas layer in parallel with the interface of the heterojunction. More specifically, when the above transistor is formed with source and drain electrodes ohmically connected with the two-dimensional electron gas layer and a gate electrode for controlling the carrier concentration of the two-dimensional electron gas layer, it can also operate as the so-called selectively-doped heterojunction type FET. In this case, a collector layer can be used as a substrate bias electrode through a collector electrode if formed.

That is, at least one bipolar transistor employing the two-dimensional carrier (or an inversion layer or accumulation layer) as the base layer and at least one field-effect transistor employing it as an active layer can be formed within an identical substrate.

The present example is an instance in which, with the aforementioned feature noticed, the device of the present invention is adopted for a large-scale integrated circuit (LSI).

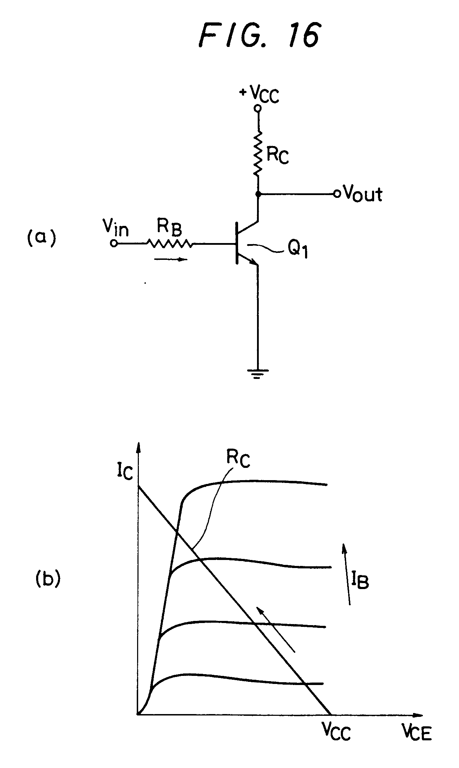

For the basic circuit which constitutes the LSI (large-scale integrated circuit), the basic circuit employed in a silicon (Si) bipolar transistor is used without any change. As found in, for example, a literature "GaAs Integrated Circuit Symposium," 1983, IEEE, p. 170, it has been common practice to employ an inverter (a basic semiconductor circuit which inverts an input potential and provides the inverted potential as an output potential) having a resistance load. The arrangement of the HBT inverter and examples of the operating characteristics thereof are illustrated in Figs. 16(a) and 16(b). In Fig. 16(a), $Q_1$ indicates an n-p-n type HBT, $R_B$ an input resistance to a base, and $R_C$ a load resistance. The relationship between the collector current $I_C$ and emitter-collector voltage $V_{CE}$ of the grounded-emitter HBT inverter as stated above is illustrated in Fig. 16(b) as static characteristics with the base current $I_B$ as a parameter. $R_C$ in the figure indicates the load resistance. As described above, in case of constructing an IC by the use of the HBT, resistances need to be formed besides the transistor, so that a process for manufacture becomes long. The large occupation area of the resistors is also a serious problem in constructing the IC.

In the present example, therefore, the load resistance was formed by a field-effect transistor utilizing a two-dimensional electron gas layer as a channel (2DEG-FET), which was formed on the same substrate as that of a heterojunction bipolar transistor utilizing the two-dimensional electron gas as carriers (2DEG-HBT). The load resistance is saturated by a lower source-drain voltage as the carrier mobility is higher, so that the 2DEG-FET functions as a nearly ideal load. Moreover, the problems mentioned above have been solved.

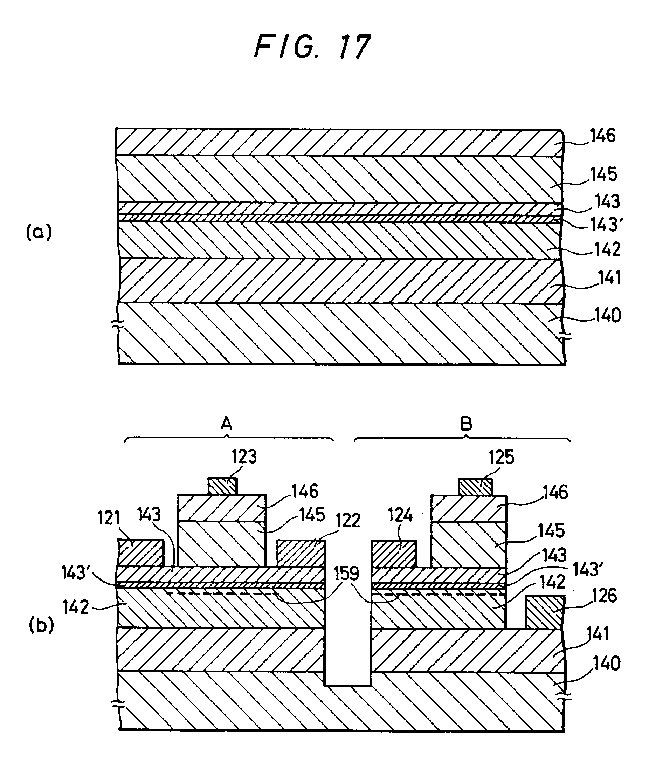

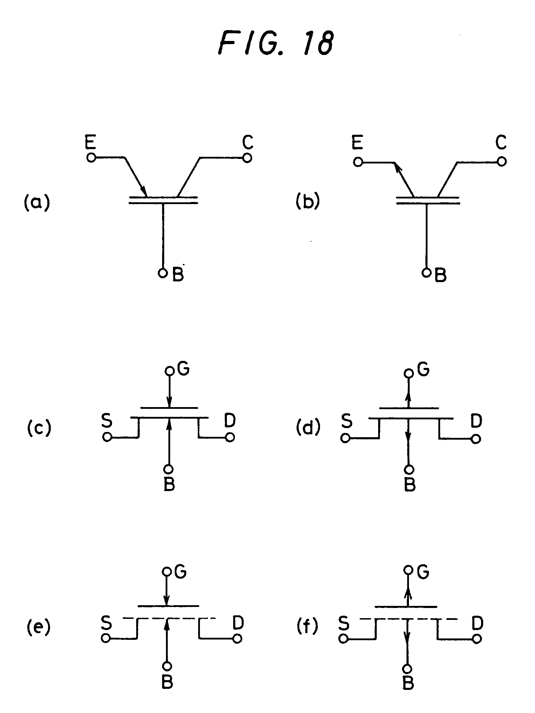

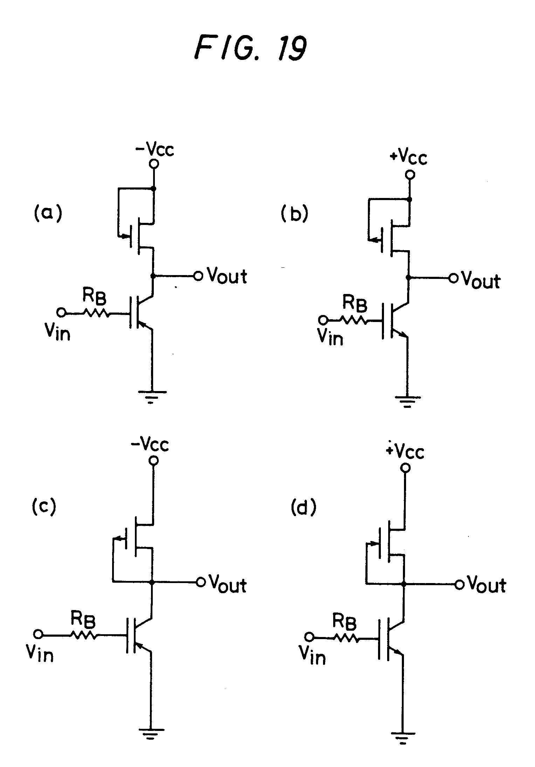

Fig. 17 illustrates sectional views showing the present example, in which Fig. 17(a) shows the lamination state of semiconductor films and Fig. 17(b) shows the formed state of an FET/a bipolar transistor, Fig. 18 illustrates diagrams showing methods of constructing semiconductor devices according to the present invention, and Figs. 19 - 21 are diagrams showing examples of applications of the semiconductor devices according to the present invention.

Referring to Fig. 17(a), $p^+$-type GaAs 141, undoped (or high purity) GaAs 142, undoped (high purity) AlGaAs 143', n-type AlGaAs 143, $p^+$-type AlGaAs 145 and $p^+$-type GaAs 146 were epitaxially grown on a semi-insulating GaAs substrate 140 by the use of crystal growth technology having a controllability at the atomic level, such as MBE (molecular-beam epitaxy) or MOCVD (organometallic chemical vapor deposition). Thereafter, by reactive ion etching (RIE) which employed a gaseous mixture consisting of $CCl_2F_2$ and He, the laminated structure was partly etched down to the semi-insulating substrate 140, to isolate an FET portion (A) and a bipolar transistor portion (B). For the isolation, the part of the laminated structure is sometimes etched down to the interior of the substrate. Next, using conventional lithographic techniques and electrode forming techniques, the selectively-doped heterojunction type FET (A) and the two-dimensional electron gas bipolar transistor (B) were formed on the identical substrate as illustrated in Fig. 17(b). A two-dimensional electron gas layer 159 was formed on the GaAs side of the interface of the heterojunction between the AlGaAs 143' and the undoped GaAs 142, and had a thickness of approximately 10 nm. In the figure, numerals 121 and 122 designate source and drain electrodes held in ohmic contact with the two-dimensional electron gas, and numeral 123 designates a gate electrode. In the example, the gate electrode 123 of the FET (A) and the emitter electrode 125 of the bipolar transistor (B) are ohmic electrodes formed on the p-type GaAs layer 146, and there is the merit that they can be formed simultaneously in the manufacturing process. However, this is not essential, but electrodes of any type capable of controlling the two-dimensional electron gas 159 may be adopted. For instance, a gate electrode may well be made by removing the p-type GaAs 146 as well as the p-type AlGaAs 145 and depositing a Schottky gate metal on the n-type AlGaAs 143. Meanwhile, the electrodes of the bipolar transistor (B) are a base electrode 124 in ohmic contact with the two-dimensional electron gas 159 (this electrode can be formed simultaneously with the source and drain electrodes of the FET), a collector electrode 126 in ohmic contact with the $p^{+}$-type GaAs 141, and the emitter electrode 125 in ohmic contact with the top layer of p-type GaAs 146. When a control electrode is provided on the p-type GaAs layer 141 under the active layer of the selectively-doped heterojunction type FET (A), it can also be used as a basic bias electrode which has been realized in an Si-MOSFET. In the case of employing the FET (A), the p-type GaAl layer 141 (the collector layer of the bipolar transistor (B) in the case of the fabrication by the epitaxial growth) is not always required, and it sometimes exerts an evil influence, such as the appearance of a parasitic capacitance, on the FET operation. On that occasion, it is possible to take such a measure meeting a purpose that a p-type GaAs layer corresponding to the collector layer is formed within the selected part of the substrate, and that the p-type GaAs layer 141 is not formed in the FET (A) portion at all or is formed only at a part underneath the gate electrode 123.

In the present example, the two-dimensional carrier stored in the identical heterojunction layer formed by the identical epitaxial growth was used as the active layer of the field-effect transistor (A) on one hand and as the base layer of the biplar transistor (B) on the other hand. However, this is not always required, but several heterojunctions may well be formed to utilize two-dimensional carriers stored in different layers, as the active layer of a field-effect transistor and as the base layer of a bipolar transistor.

Although, in the above, the case of employing the two-dimensional electron gas layer has been described, a two-dimensional hole gas layer may well be employed. As regards the present example utilizing the two-dimensional carriers as both the base layer of the bipolar transistor and the active layer of the field-effect transistor, there are, in general, combinations listed in Table 1:

Table 1

| Combination of Active Layer and Base Layer | FET | Bipolar |
|---|---|---|
| | 2DEG | 2DEG |
| | 2DHG | 2DHG |
| | 2DEG | 2DHG |
| | 2DHG | 2DEG |
| (Note) 2DEG = Two-dimensional electron gas 2DHG = Two-dimensional hole gas | | |

Shown in Figs. 18(a) and 18(b) are transistor symbols in the case of utilizing the two-dimensional carrier (or the like layer) for the bipolar transistor as described above. (a) corresponds to the case of employing the two-dimensional electron layer as the base layer, while (b) the case of employing the two-dimensional hole gas layer. Letters E, B and C in the figures indicate an emitter, a base and a collector, respectively. Besides, transistor symbols in the case of utilizing the two-dimensional carrier for the field-effect transistor are shown in Figs. 18(c), 18(d), 18(e) and 18(f). This case is also divided into the case of employing the two-dimensional electron layer ((c), (e)) and the case of employing the two-dimensional hole layer ((d), (f)). It is the same as in conventional FET's that the FET's of the invention are classified into a depletion mode in which a channel layer is open at a gate voltage of 0 V ((c), (d)) and an enhancement mode in which a channel layer is closed thereat. Letters S, G and D in the figures indicate source, gate and drain electrodes, respectively, and a substrate bias electrode B is omitted when not employed.

Next, the validness of the present invention will be described in conjunction with various examples of

EP 0 240 567 B1

applications.

Figs. 19(a) - 19(d) exemplify basic inverter circuits each of which employs the bipolar transistor and field-effect transistor of the present invention. Symbol $R_B$ in the drawing denotes a resistance serial to a base, which is provided for stabilizing current. Likewise to the case of conventional circuits, in the presence of the resistances $R_B$, RTL (Resistor Transistor Logic) can be constructed using the inverters as shown in Fig. 19, and in the absence of the resistances $R_B$, DCTL (Direct Coupled Transistor Logic) can be formed using the inverters.

The merit of the use of the depletion-mode field-effect transistor (D-FET) as the load of the bipolar transistor as stated above is to be understood from the circuit operation of the inverter illustrated in Fig. 19-(a). By properly selecting the dimensions of the bipolar transistor and the field-effect transistor, a favorable inverter characteristic is demonstrated, and the delay time of the circuitry can be sharply shortened. The reason why the delay time of the circuitry can be improved is almost the same as in the case of employing a D-FET load in a prior-art field-effect transistor circuit. In the case of the bipolar transistor of the present example employing the two-dimensional carrier as the base layer, however, the effect of accumulating minority carriers in a saturation region is much less than in the conventional bipolar transistor, which is very advantageous for constructing a circuit.

In addition, memory cells can be constructed using the basic inverter circuits as stated above.

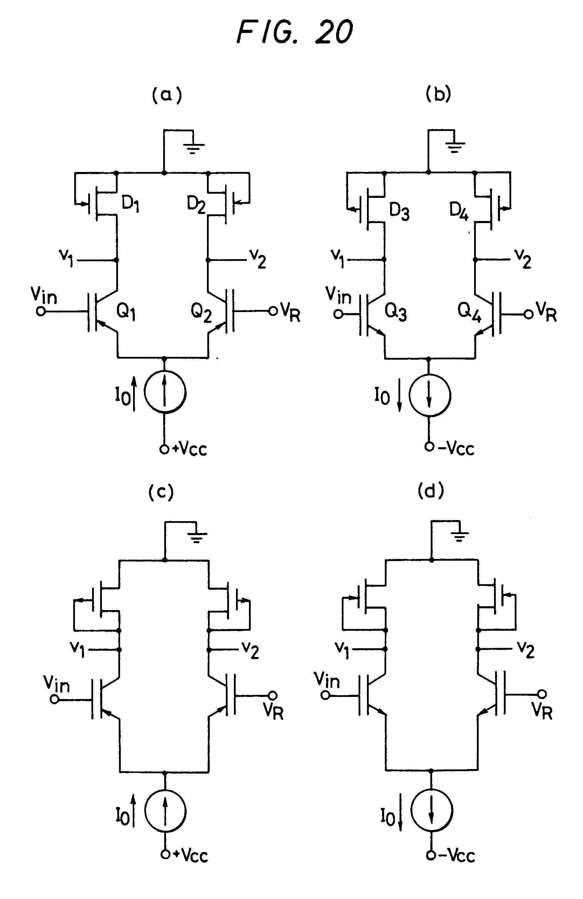

Next, basic inverter circuits in the case of arranging CML (Current Mode Logic) or ECL (Emitter Coupled Logic) with the semiconductor devices of the present example are illustrated in Fig. 20. As apparent from the illustrated examples of applications, the CML basic inverter is constructed by combining the basic inverters shown in the foregoing examples of applications. With such a CML inverter, the base resistance can be lowered. In the case of using the GaAs/AlGaAs heterojunction, therefore, the delay time is shortened to 1/2 - 1/3 of that of a CML inverter of resistance load at the normal temperature and to 1/3 - 1/4 at 77 ° K.

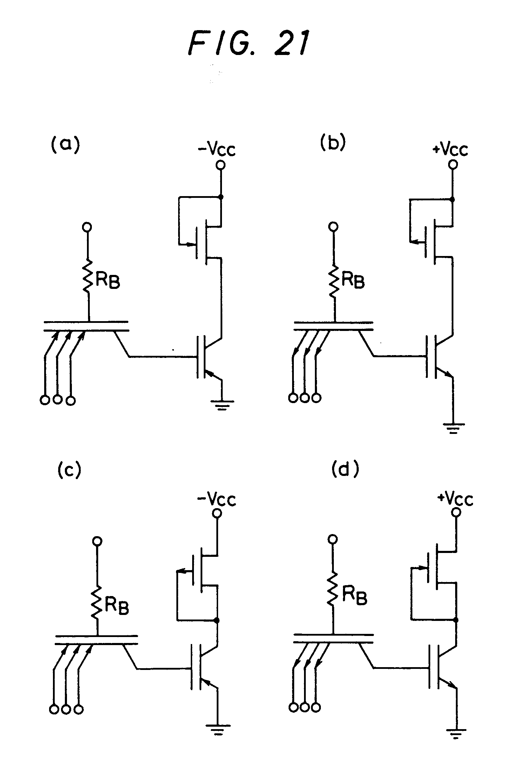

Examples of applications in the case of employing the semiconductor devices of the present example for gate circuits of TTL (Transistor Transistor Logic) are illustrated in Fig. 21. Besides these examples of applications, a circuit employing the prior-art bipolar transistor can have its operating speed raised in such a way that its part of a load resistance is replaced with the field-effect transistor according to the present invention in which the two-dimensional carrier is utilized for the active layer.

As stated above, in the semiconductor device according to the present example, at least one selectively-doped heterojunction type field-effect transistor in which a two-dimensional carrier formed at the interface of the heterojunction of semiconductors on a substrate was utilized as the active layer of a field-effect transistor and at least one heterojunction type bipolar transistor in which the two-dimensional carrier was utilized as the base layer of a bipolar transistor were formed and coupled on the substrate, whereby the n-channel FET and the p-n-p bipolar transistor could be readily formed on the identical substrate, and merits in constructing circuits could be attained.

Especially in the ECL (Emitter Coupled Logic) circuit, an FET utilizing a two-dimensional carrier as a load resistance could be used, so that an operating speed double higher than in the prior art could be attained. Further, an operating speed 3 - 4 times as high as that of the prior art could be attained by lowering the temperature to 77 K.

**Industrial Applicability:**

Heretofore, a heterojunction bipolar transistor (HBT) employing a heterojunction of $Ga_{x-1}Al_xAs/GaAs$ has been difficult of simultaneously achieving the two themes of reducing a base width and lowering the resistance of a base region.

Enhancement in the performance of the HBT itself leads to the enhanced performance of a circuit employing the HBT, and is important at present at which an arithmetic or storage device of higher performance is required.

The present invention solves the above difficulty hampering the enhancement of the performance of the HBT, to provide the HBT of higher performance, and also makes it possible to form a field-effect transistor and the HBT on an identical epitaxial substrate, which is useful for integrating circuits and has a very great industrial value.

**Claims**

1. A semiconductor device having a bipolar transistor comprising
   an emitter region (35) of a first conductivity type,

15

EP 0 240 567 B1

a collector region (23) of the first conductivity type,

a base region (33, 34, 24) interposed between the emitter and collector regions, said base region having a first region (32,24) of a substantially undoped first compound semiconductor and a second region (33,34) of a second compound semiconductor of a second conductivity type, said second conductivity type being opposite to said first conductivity type, said first and second regions forming a heterojunction so that a two-dimensional carrier gas layer (26) of the second conductivity type is induced in the first compound semiconductor region (32, 24).

2. The device according to claim 1, wherein the first compound semiconductor is GaAs and the second compound semiconductor is GaAlAs.

3. The device according to claim 1, wherein the first conductivity type is a p-type, the second conductivity type is a n-type and the two-dimensional carrier gas layer is a two-dimensional electron gas layer.

4. The device according to claim 1, wherein the first region has a $p^-$-conductivity type.

5. The device according to claim 1, wherein a width of the two-dimensional carrier gas layer is in a range of 10 nm to 15 nm.

6. The device according to claim 1, wherein the two-dimensional carrier gas layer in the first region (32 or 24) is caused by an energy difference between the band edge structures of the first compound semiconductor (32 or 24) and the second compound semiconductor (33, 34).

7. The device according to claim 1, wherein the base region is depleted except the part of the two-dimensional carrier gas layer.

8. The device according to claim 1, wherein the base region is formed with two heterostructures.

9. The device according to claim 1, wherein at least one of said base, collector and emitter regions comprises a superlattice constructed of a third compound semiconductor whose donor-level or acceptor-level is not higher than the thermal energy corresponding to the temperature 77 K, and a fourth compound semiconductor which is not doped with an impurity and which is smaller in an electron affinity or greater in a sum of the electron affinity and an energy band gap than said third compound semiconductor.

10. The device according to claim 1, wherein electrodes for the base (70), collector (72) and emitter (71) are provided on the same surface, lead-out portions (65; 66) connecting the base and the collector regions (54; 55) to the respective electrodes (72; 70) being formed by ion-implantation through the layer structure and being electrically separated from the transistor region.

11. The device according to claim 1, including a field effect transistor (A) the channel region of which has a substantially undoped third region (142) of the first compound semiconductor and a fourth region (143, 143') of the second compound semiconductor of the second conductivity type, said third and fourth regions forming a heterojunction, so that a two-dimensional carrier gas layer (159) of the second conductivity type is induced in the first compound semiconductor region (142).

**Patentansprüche**

1. Halbleitereinrichtung mit einem Bipolartransistor, der umfaßt:

einen Emitterbereich (35) eines ersten Leitfähigkeitstyps,

einen Kollektorbereich (23) des ersten Leitfähigkeitstyps, einen zwischen den Emitter- und Kollektorbereichen angeordneten Basisbereich (33, 34, 35), der einen ersten Bereich (32, 24) aus einem im wesentlichen undotierten ersten Verbundhalbleiter und einen zweiten Bereich (33, 34) aus einem zweiten Verbundhalbleiter eines zu dem ersten Leitfähigkeitstyp entgegengesetzten zweiten Leitfähigkeitentyps aufweist, wobei der erste und der zweite Bereich einen Heteroübergang bilden, so daß in dem ersten Vebundhalbleiterbereich (32, 24) eine zweidimensionaie Trägergasschicht (26) des zweiten Leitfähigkeitstyps indoziert wird.

16

**2.** Einrichtung nach Anspruch 1, wobei der erste Verbundhalbleiter GaAs und der zweite Verbundhalbleiter GaAlAs ist.

**3.** Einrichtung nach Anspruch 1, wobei der erste Leitfähigkeitstyp ein p-Typ, der zweite Leitfähigkeitstyp ein n-Typ und die zweidimensionale Trägergasschicht eine zweidimensionale Elektronengasschicht ist.

**4.** Einrichtung nach Anspruch 1, wobei der erste Bereich einen $p^-$-Leitfähigkeitstyps aufweist.

**5.** Einrichtung nach Anspruch 1, wobei die Breite der zweidimensionalen Trägergasschicht im Bereich von 10 nm bis 15 nm liegt.

**6.** Einrichtung nach Anspruch 1, wobei die zweidimensionale Trägergasschicht in dem ersten Bereich (32 oder 24) durch einen Energieunterschied zwischen den Bandkanten Strukturen des ersten Verbundhalbleiters (32 oder 24) und dem zweiten Verbundhalbleiter (33, 34) bewirkt wird.

**7.** Einrichtung nach Anspruch 1, wobei der Basisbereich mit Ausnahme des Teils der zweidimensionalen Trägergasschicht verarmt ist.

**8.** Einrichtung nach Anspruch 1, wobei der Basisbereich mit zwei Hetero-Strukturen gebildet ist.

**9.** Einrichtung nach Anspruch 1, wobei mindestens einer der Basis-, Kollektor- und Emitterbereiche ein Superlattis umfaßt, das aus einem dritten Verbundhalbleiter, dessen Donnatoren- oder Akzeptoren-Pegel nicht höher ist als die der Temperatur 77 K entsprechende thermische Energie, und einem vierten Verbundhalbleiter aufgebaut ist, der nicht Störstoff-Dotiert ist und eine geringere Elektronenaffinität oder eine größere Summe aus Elektronenaffinität und Bandabstand aufweist als der dritte Verbundhalbleiter.

**10.** Einrichtung nach Anspruch 1, wobei Elektroden für die Basis (70), den Kollektor (72) und den Emitter (71) auf der gleichen Oberfläche vorgesehen und die Basis- und Kollektorbereiche (54; 55) mit den jeweiligen Elektroden (72; 70) verbindende Leiterteile (65; 66) durch Ionenimplantation durch die Schichtstruktur gebildet und von dem Transistorbereich elektrisch getrennt sind.

**11.** Einrichtung nach Anspruch 1 mit einem Feldeffekttransistor (A), dessen Kanalbereich einen ersten Bereich (142) aus einem im wesentlichen undotierten ersten Verbundhalbleiter und einen zweiten Bereich (143, 143') aus einem zweiten Verbundhalbleiter des zweiten Leitfähigkeitstyps aufweist, so daß in dem ersten Verbundhalbleiterbereich (142) eine zweidimensionale Trägergasschicht (159) des zweiten Leitfähigkeitstyps indoziert wird.

**Revendications**

**1.** Dispositif à semiconducteurs comportant un transistor bipolaire comprenant
une région d'émetteur (35) possédant un premier type de conductivité,
une région de collecteur (23) possédant le premier type de conductivité,
une région de base (33,34,24) intercalée entre les régions d'émetteur et de collecteur, ladite région de base possédant une première région (32,24) formée d'un premier semiconducteur composite sensiblement non dopé, et une seconde région (33,34) formée d'un second semiconducteur composite possédant un second type de conductivité, ledit second type de conductivité étant opposé audit premier type de conductivité, lesdites première et seconde régions formant une hétérojonction de sorte qu'une couche (26) formée d'un nuage bidimensionnel de porteurs possédant le second type de conductivité est induite dans la première région semiconductrice composite (32,24).

**2.** Dispositif selon la revendication 1, dans lequel le premier semiconducteur composite est du GaAs et le second semiconducteur composite est du GaAlAs.

**3.** Dispositif selon la revendication 1, dans lequel le premier type de conductivité est un type p, le second type de conductivité est un type n et la couche formée par le nuage bidimensionnel de porteurs est une couche formée d'un nuage bidimensionnel d'électrons.

**4.** Dispositif selon la revendication 1, dans lequel la première région possède un type de conductivité p⁻.

**5.** Dispositif selon la revendication 1, dans lequel une largeur de la couche formée du nuage bidimensionnel de porteurs se situe dans une gamme comprise entre 10 nm et 15 nm.

**6.** Dispositif selon la revendication 1, dans lequel la couche formée du nuage bidimensionnel de porteurs dans la première région (32 ou 24) est provoquée par une différence d'énergie entre les structures des bords de bandes du premier semiconducteur composite (32 ou 24) et du second semiconducteur composite (33, 34).

**7.** Dispositif selon la revendication 1, dans lequel la région de base est appauvrie en dehors de la partie de la couche formée par le nuage bidimensionnel de porteurs.

**8.** Dispositif selon la revendication 1, dans lequel la région de base est formée avec deux hétérostructures.

**9.** Dispositif selon la revendication 1, dans lequel au moins l'une desdites régions de base, de collecteur et d'émetteur comprend un super-réseau constitué par un troisième semiconducteur composite, dont le niveau des donneurs ou le niveau des accepteurs n est pas supérieur à l'énergie thermique correspondant à la température 77 K, et un quatrième semiconducteur composite qui n'est pas dopé par une impureté et qui présente une affinité plus faible pour les électrons ou pour lequel la somme de l'affinité pour les électrons et la bande interdite d'énergie est supérieure à celle dudit troisième semiconducteur composite.

**10.** Dispositif selon la revendication 1, dans lequel des électrodes pour la base (70), le collecteur (72) et l'émetteur (71) sont prévues sur la même surface, des parties ressorties (65;66) raccordant les régions de base et de collecteur (54;55) aux électrodes respectives (72;70) étant formées par implantation ionique dans la structure de couche et étant électriquement séparées de la région du transistor.

**11.** Dispositif selon la revendication 1, comprenant un transistor à effet de champ (A), dont la région de canal possède une première région (142) formée d'un premier semiconducteur composite sensiblement non dopé et une seconde région (143,143') formée d'un second semiconducteur composite possédant le second type de conductivité, de sorte qu'une couche (159) formée par un nuage bidimensionnel de porteurs possédant le second type de conductivité est induite dans la première région semiconductrice composite (142).

# FIG. 1

# FIG. 2

(a)

(b)

11 12 13 14

16
18
17
15

# FIG. 3

# FIG. 4

(a)

40    39  38    37              36

(b)

27

25

# FIG. 5

(a)

57
56
55
54
53
52
51

(b)

58
58
59
60
58
57
56
55
54
53
52
51
61

# FIG. 6

(a)

64
63
55
54
53
52
62

(b)

69  58  72  68  64  71  67  66  70  58  69

65

64
63
55
54
53
52
62

# FIG. 7

(a)

79
78
77
76
75
74
73

(b)

58    58    80

58
79
78
82
77
76
75
74
73
81

# FIG. 8

## FIG. 8

(c)

55
54
85
84
83
53

59

58
57
56
55
54
85
84
83
53
52
51

(d)

## FIG. 9

91

+ + +    + + +    + + +    + +    + + +

92

## FIG. 10

(a)

(b)

## FIG. 11

(a)

57
56'
55'
54

(b)

Aℓ COMPOSITION x OF GaAℓAs

0.5
0.4
0.3
0.2
0.1
0.0

54    55'    56'

(c)

200

199

## FIG. 12

(a)

35'  33'  32  31

(b)

19

$E_F$

(c)

351  352

35'

(d)

331  332

33'

(e)

19  19'  32

33'  132  133

# F/G. 13

# FIG. 14

(a)

36'
35'
33'
32
31
30

(b)

58        58        60

58
36'
35'
33'
32
31
30

59

61

## FIG. 15

(a)

177
176
175
174
173
172
171
170

(b)

158    158    168

169

177
176
175
174
173
172
171
170
167

# FIG. 16

(a)

(b)

# FIG. 17

(a)

146
145
143
143'
142
141
140

A          B

123          125

121  143    146          124    146
          145  122          145  143'
143'                          143'
142                          142  126
          159
(b)
142                          141
          140

# FIG. 18

(a)

(b)

(c)

(d)

(e)

(f)

## FIG. 19

(a)

−Vcc

Vout

RB

Vin

(b)

+Vcc

Vout

RB

Vin

(c)

−Vcc

Vout

RB

Vin

(d)

+Vcc

Vout

RB

Vin

*FIG. 20*

(a)

(b)

(c)

(d)

# F I G. 21

(a)

(b)

(c)

(d)